# Europäisches Patentamt

# European Patent Office

# Office européen des brevets

(19)

(11) Numéro de publication: **0 086 136**
**B1**

(12) # FASCICULE DE BREVET EUROPÉEN

(45) Date de publication du fascicule du brevet:
**13.08.86**

(51) Int. Cl.⁴: **H 03 K 3/537**

(21) Numéro de dépôt: **83400171.1**

(22) Date de dépôt: **25.01.83**

(54) Générateur d'impulsions électromagnétiques de haute tension.

(30) Priorité: **04.02.82 FR 8201812**

(43) Date de publication de la demande:
**17.08.83 Bulletin 83/33**

(45) Mention de la délivrance du brevet:
**13.08.86 Bulletin 86/33**

(84) Etats contractants désignés:
**CH DE GB LI**

(56) Documents cité:
**US-A-3 071 710**

**TECHNIQUES CEM, no. 100/101, décembre 1977,
pages 57-59, paris, FR J.C. COUPAIN et al.:
"Générateur d'impulsion 200kV à temps de montée
rapide"
JOURNAL OF SCIENTIFIC INSTRUMENTS
(JOURNAL OF PHYSICS E), série 2, vol. 2, no. 6;
juin 1969, page 503-505, Londres, GB D.L. PULFREY:
"A generator of high voltage pulses with
subnanosecond risetime and adjustable duration"
L'ONDE ELECTRIQUE, vol. 48, no. 474, mai 1968,
pages 430-437, Paris, FR H. BACCHI et al.:
"Générateurs d'impulsions haute tension de 1
nanoseconde à mi-hauteur"**

(73) Titulaire: **COMMISSARIAT A L'ENERGIE
ATOMIQUE Etablissement de Caractère
Scientifique Technique et Industriel, 31/33, rue
de la Fédération, F-75015 Paris (FR)**

(72) Inventeur: **Bouquet, Gerard, Lotissement de
Lucildo, F-33600 Pessac (FR)**

(74) Mandataire: **Mongrédien, André, c/o BREVATOME
25, rue de Ponthieu, F-75008 Paris (FR)**

## Description

La présente invention a pour objet un générateur d'impulsions électromagnétiques de haute tension. Ce générateur d'impulsions peut être notamment utilisé pour tester la tenue de certains dispositifs tels que des composants électroniques, sous des impulsions de haute tension, comme par exemple sous des impulsions de 30 à 300 kV, avec des fronts de montée d'une durée inférieure à 5 ns.

Les générateurs d'impulsions électromagnétiques actuellement connus, ne permettent pas une telle application étant donné l'existence d'une self globale trop élevée, cette self globale étant constituée par les selfs propres des différents constituants du générateur ainsi que des selfs de liaison, résultant de la connexion de ces différents constituants entre eux.

On connaît aussi des générateurs d'impulsions haute tension comportant un condensateur chargé sous haute tension, un éclateur servant à décharger le condenseur de façon impulsionnelle et une résistance de charge, formant une ligne coaxiale d'impédance constante. De tels générateurs sont décrits dans les documents US-A- 3 071 710, l'onde électrique, vol. 48, n° 474, mai 1968, pages 430-437, et Techniques CEM n° 100/101, décembre 1977, pages 56-59.

La présente invention a justement pour objet un générateur d'impulsions électromagnétiques de haute tension permettant de supprimer l'effet de cette self. Ce générateur peut donc être utilisé, notamment dans l'application décrite ci-dessus.

De façon plus précise, l'invention a pour objet un générateur d'impulsions électromagnétiques de haute tension, comprenant de façon connue:

- un condensateur présentant un axe de révolution, disposé autour d'un conducteur interne présentant un axe de révolution confondu avec celui du condensateur, ce condensateur pouvant être chargé au moyen d'une source d'alimentation électrique de haute tension continue,

- un éclateur, dont l'axe de révolution peut être confondu avec celui du condensateur, comportant au moins deux électrodes, une électrode externe et une électrode interne, et permettant de décharger de façon impulsionnelle le condensateur,

- une résistance de charge, l'électrode externe de l'éclateur étant reliée directement à la borne haute tension de la source d'alimentation électrique et l'électrode interne dudit éclateur étant reliée à la masse de ladite source d'alimentation, par l'intermédiaire du conducteur interne et de la résistance de charge, et

- des moyens de commande de l'éclateur, le condensateur, l'éclateur et la résistance de charge formant avec le conducteur interne une ligne coaxiale, caractérisé en ce que l'éclateur présente une forme conique et la résistance de charge, reliée en série avec l'éclateur, présente un axe de révolution, l'impédance de la ligne étant constante tout le long de ladite ligne.

L'impédance de la ligne de ce générateur est par exemple voisine de 50 ohms. Ceci permet de s'affranchir des problèmes liés aux selfs. Ce générateur peut donc engendrer des impulsions réglables présentant une tension comprise entre 30 et 300 kV avec un front de montée d'une durée inférieure à 5 ns.

Selon un mode préféré de réalisation du générateur de l'invention, l'extrémité de l'électrode interne, en regard de l'électrode externe, présente une forme convexe.

Selon un autre mode préféré de réalisation du générateur de l'invention, la partie de l'électrode externe située en regard de l'extrémité de l'électrode interne présente une forme plane.

Selon un autre mode préféré de réalisation du générateur de l'invention, le condensateur est disposé autour d'un support cylindrique isolant dans lequel est logé le conducteur interne, l'ensemble constituant une ligne coaxiale.

Selon un autre mode préféré de réalisation du générateur de l'invention, la résistance de charge est constituée d'une nappe d'un électrolyte aqueux dont l'épaisseur varie de façon inversement proportionnelle au rayon de ladite nappe.

Selon un autre mode préféré de réalisation du générateur de l'invention, ce dernier comprend une gâchette placée dans un alésage pratiqué dans la partie plane de l'électrode externe. Dans ce mode de réalisation, les moyens de commande de l'éclateur comprennent par exemple un autre condensateur pouvant être chargé au moyen d'une autre source d'alimentation électrique continue, un autre éclateur permettant de décharger de façon impulsionnelle ledit autre condensateur et un transformateur d'isolement dont le primaire est connecté entre ledit autre condensateur et la masse de ladite autre source d'alimentation et dont le secondaire est relié entre l'électrode externe et la gâchette.

D'autres caractéristiques et avantages de l'invention ressortiront mieux à la lecture de la description qui suit, donnée à titre explicatif mais nullement limitatif, en référence aux figures annexées, sur lesquelles:

- la figure 1 représente, schématiquement, une vue en coupe d'un générateur d'impulsions, conformément à l'invention,

- la figure 2 est un schéma synoptique du circuit de décharge du générateur d'impulsions de la figure 1, et

- la figure 3 représente, schématiquement, une vue en coupe de l'éclateur du générateur d'impulsions de la figure 1.

En se référant aux différentes figures, le générateur d'impulsions électromagnétiques, conformément à l'invention, comprend, un condensateur 2 présentant un axe de révolution 4 et disposé autour d'un conducteur interne 5 présentant un axe de révolution confondu avec celui du condensateur. Le générateur comprend encore un éclateur 6 de forme conique, dont l'axe de révolution est notamment confondu avec celui du condensateur, et une résistance de charge 8, présentant un axe de révolution qui peut être confondu ou non avec l'axe de revolution 4 du condensateur. Pour des raisons pratiques ces différents éléments constitutifs du générateur d'impulsions doivent être prévus démontables.

Ce générateur comprend, de plus, une source d'alimentation électrique de haute tension continue, branchée aux bornes du condensateur 2 et permettant de charger ce dernier. La décharge de façon impulsionnelle du condensateur 2 est effectuée au moyen de l'éclateur 6 dont la commande est effectuée notamment au moyen d'un système 10.

Selon l'invention, le condensateur 2, l'éclateur 6 et la résistance de charge 8 définissent avec le conducteur interne 5 une ligne coaxiale présentant une impédance constante tout le long de la ligne. L'impédance de cette ligne est par exemple voisine de 50 ohms.

Lorsque l'on cherche à respecter au mieux le principe de l'adaptation d'impédance tout le long de la ligne coaxiale, constituant le générateur, on s'aperçoit que cela est impossible à réaliser dans la région de l'éclateur où se produit l'étincelle. Pour respecter ce principe, il est donc nécessaire de donner à ladite région des dimensions les plus faibles possibles. L'emploi d'un éclateur de forme conique permet de résoudre ce problème d'impédance.

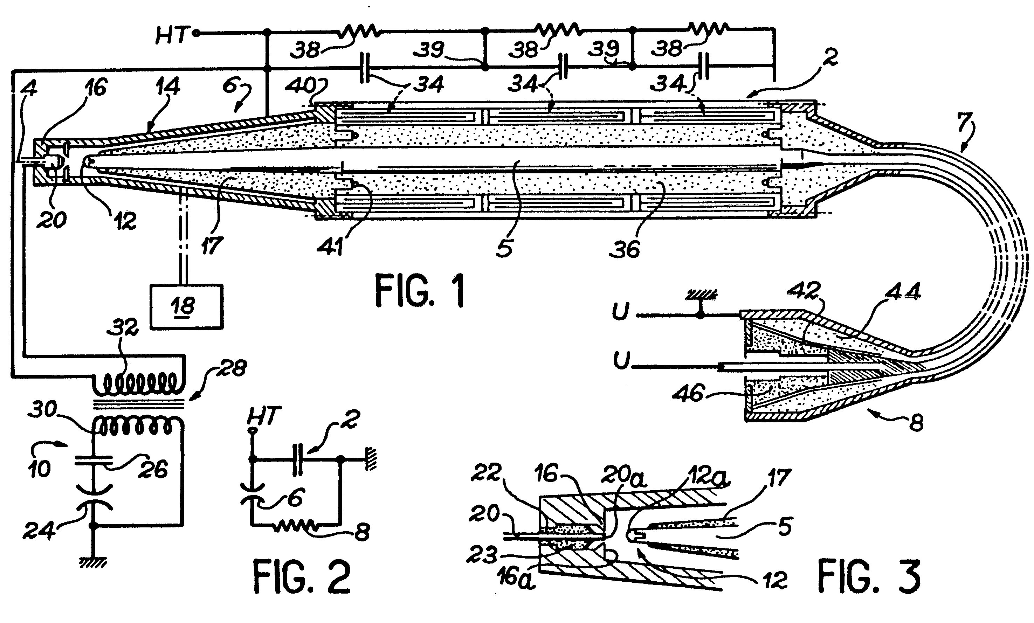

La résistance de charge 8 est connectée à l'ensemble, formé de l'éclateur 6 et du condensateur 8, soit directement au moyen de vis, soit par l'intermédiaire d'un câble 7, comme représenté sur la figure 1, ce câble présentant la même impédance que celle de la ligne coaxiale définie ci-dessus.

Du point de vue branchement électrique, la résistance de charge 8, comme représenté sur la figure 2, est branchée en série avec l'éclateur 6, et l'ensemble, constitué de la résistance et de l'éclateur, est branché aux bornes du condensateur 2, donc aux bornes de la source d'alimentation électrique de haute tension continue.

Selon l'invention, l'éclateur 6 est constitué d'au moins deux électrodes, une électrode interne 12 et une électrode externe 14, jouant un rôle d'enveloppe étanche, réalisée en métal. Etant donné que les tensions qui peuvent être tenues par l'éclateur sont très élevées, la longueur de l'électrode externe 14 devra être très élevée.

De préférence, l'extrémité 12a de l'électrode interne 12, en regard de l'électrode externe 14, présente une forme convexe telle qu'hémisphérique tandis que la partie 16 de l'électrode externe, faisant face à ladite extrémité 12a, présente une forme plane. Ceci est illustré sur la figure 3.

L'électrode interne 12, logée dans une pièce isolante 17 de forme conique, est reliée à la masse de la source d'alimentation électrique haute tension (HT) par l'intermédiaire de la résistance de charge 8, et l'électrode externe 14 est reliée directement à la borne haute tension (HT) de cette même source d'alimentation électrique (figure 1).

L'éclateur 6 est un éclateur du type à gaz sous pression. L'alimentation en gaz de l'éclateur est effectuée par l'intermédiaire d'un système réglable approprié 18. Selon la tenue en tension désirée, les gaz utilisés seront soit de l'hexafluorure de soufre, soit de l'azote. Ce dernier pouvant être comprimé à des pressions allant jusqu'à 25 bars, l'électrode externe 14 jouant le rôle d'enveloppe, doit pouvoir résister à de telles pressions. Dans ce type d'éclateur, l'amorçage se produit par dépressurisation de l'éclateur.

Etant donné l'emploi des pressions de gaz élevées dans l'éclateur et la faible tenue en traction des matériaux isolants pouvant être employés pour constituer la pièce isolante 17 dudit éclateur (matières plastiques, céramiques), il est préférable de faire travailler lesdits matériaux en compression. Ceci est notamment obtenu en utilisant un éclateur de forme conique. En effet, la pression du gaz dans l'espace compris entre l'électrode externe 14 et la pièce isolante 17 va faire s'arc-bouter la pièce isolante contre l'électrode 14 et donc faire travailler le matériau isolant constituant la pièce 17 dans le sens désiré.

Des études ont montré que le claquage de l'éclateur 6 ne s'effectuait pas toujours axialement, c'est-à-dire entre l'extrémité 12a de l'électrode 12 et la partie plane 16 de l'électrode 14. En effet, le claquage apparaît parfois latéralement dans l'espace compris entre l'électrode externe 14 et la pièce isolante 17. Le fait d'utiliser un éclateur de forme conique permet d'obtenir un espace de longueur importante, ce qui permet d'éviter un tel claquage.

Par ailleurs, on peut utiliser un éclateur 6 du type triode, comportant, en plus des électrodes 12 et 14, une gâchette 20, comme cela est représenté sur la figure 3. Cette gâchette 20 est placée dans un alésage 22 pratiqué dans la partie plane 16 de l'électrode externe 14 et disposée de façon que l'extrémité 20a de la gâchette affleure avec la partie interne 16a de la partie 16 de l'électrode externe. Afin d'éviter toute fuite de gaz de l'intérieur vers l'extérieur de l'éclateur, un matériau isolant de remplissage 23 de l'alésage 22 est prévu.

Comme on l'a dit précédemment, la commande de l'éclateur et en particulier de l'éclateur du type triode, est effectuée au moyen d'un système 10. Ce système 10, du type électromagnétique, comprend un interrupteur tel que par exemple un éclateur 24 branché aux bornes d'une deuxième source d'alimentation électrique continue, un condensateur 26 pouvant être chargé au moyen de cette deuxième source d'alimentation, et un transformateur d'isolement 28 qui peut être aussi élévateur de tension, dont le primaire 30 est connecté entre le condensateur 26 et la masse de la deuxième source d'alimentation, et dont le secondaire 32 est relié entre l'électrode externe 14 et la gâchette 20.

Lorsque l'on commande la fermeture de l'interrupteur 24, le condensateur 26 se décharge à travers le primaire 30 du transformateur 28. La tension produite, alors, dans le secondaire 32 du transformateur provoque une etincelle entre la gâchette 20 et l'electrode externe 14, entraînant une étincelle entre l'extrémité 12a de l'électrode interne 12 et la partie plane 16 de l'électrode externe 14. Le claquage de l'éclateur 6 engendre alors la décharge impulsionnelle du condensateur 2 donnant naissance à des impulsions de sortie de haute tension.

L'utilisation d'un tel système de commande permet d'engendrer des signaux reproductibles, aussi bien du point de vue de la forme et de l'amplitude que de la vitesse de montée de ces signaux.

Selon l'invention, le condensateur 2 du générateur peut être formé, soit d'un unique condensateur, soit de plusieurs condensateurs 34, montés en série et/ou en parallèle. Ce ou ces condensateurs présentent la forme de cylindres creux, disposés autour d'un support cylindrique isolant 36 réalisé par exemple en PVC, dans lequel est logé le conducteur interne 5. L'ensemble formé du condensateur, du support cylindrique et du conducteur interne, constitue une ligne coaxiale dont l'impédance est par exemple égale à 50 ohms.

Lorsque l'on utilise plusieurs condensateurs montés en série, il convient de prévoir des résistances de charge 38, branchées chacune en parallèle avec le condensateur correspondant 34, comme cela est schématisé sur la partie supérieure de la figure 1. Ces résistances servent a imposer des tensions adéquates aux points intermédiaires 39.

Comme on l'a dit précédemment, les différents éléments constituant le générateur d'impulsions doivent être démontables, et en particulier en ce qui concerne l'ensemble formé du condensateur et de l'éclateur. Les vis telles que 40 permettent la fixation de l'éclateur sur le condensateur.

Par ailleurs, des joints d'étanchéité tels que 41 doivant âtre prévus, afin d'éviter un claquage éventuel entre la masse et la haute tension, c'est-à-dire entre le condensateur et le conducteur interne.

La résistance de charge 8 peut être constituée d'une nappe d'électrolyte aqueux 42, de révolution, intercalée entre deux pièces isolantes 44 et 48. L'électrolyte choisi est par exemple une solution de chlorure de sodium.

De façon que la puissance dissipée dans l'électrolyte soit constante, l'épaisseur de la nappe varie de façon inversement proportionnelle au rayon de la nappe. La génératrice de cette nappe de révolution est déterminée de façon que l'adaptation d'impédance soit conservée d'un bout à l'autre de la résistance de charge. L'impédance de cette nappe d'électrolyte est par exemple égale à 50 ohms.

Bien entendu, ceci n'est qu'un exemple de réalisation de la résistance de charge; celle-ci peut notamment être constituée de plusieurs résistances au carbone du commerce, montées en série-parallèle.

Dans l'application du générateur d'impulsions pour tester des composants électroniques, ces derniers doivent être montés en parallèle avec la résistance de charge 8, c'est-à-dire aux bornes de sortie du générateur notées U, au moyen d'un connecteur spécifique dont la structure est fonction des composants à tester.

On va maintenant donner un exemple de réalisation du générateur d'impulsions tel que décrit précédemment.

Le condensateur 2 peut être formé de trois condensateurs élémentaires montés en série ayant une capacité de 180 nF et présentant un diamètre interne de 200 mm, un diamètre externe de 255 mm et une longueur de 306 mm, ces condensateurs ayant une tenue en tension au moins égale à 50 kV. La résistance 38 branchée aux bornes de chacun de ces condensateurs élémentaires est prise égale à 250 M/L

En ce qui concerne l'éclateur, celui-ci présente une longueur de 400 mm.

En ce qui concerne le système de commande 10 de l'éclateur 6, du type triode, la tension délivrée par la deuxième source d'alimentation électrique est prise égale à 7 kV, la capacité du condensateur 24 est prise égale à 100 nF et les nombres de spires du primaire et du secondaire du transformateur élévateur de tension sont pris respectivement égaux à 15 et 40.

## Revendications

1. Générateur d'impulsions électromagnétiques de haute tension, comprenant:
- un condensateur (2) présentant un axe de révolution (4), disposé autour d'un conducteur interne (5) présentant un axe de révolution confondu avec celui du condensateur, ce condensateur pouvant être chargé au moyen d'une source d'alimentation électrique de haute tension continue,
- un éclateur (6), dont l'axe de révolution peut être confondu avec celui du condensateur, comportant au moins deux électrodes, une électrode externe (14) et une électrode interne (12), et permettant de décharger de façon impulsionnelle le condensateur,
- une résistance de charge (8), l'électrode externe (14) de l'éclateur (6) étant reliée directement à la borne haute tension (HT) de la source d'alimentation électrique et l'électrode interne (12) dudit éclateur (6) étant reliée à la masse de ladite source d'alimentation, par l'intermédiaire du conducteur interne (5) et de la résistance de charge (8), et
- des moyens (10, 18) de commande de l'éclateur, le condensateur, l'éclateur et la résistance de charge constituant avec le conducteur interne une ligne coaxiale, caractérisé en ce que l'éclateur (6) présente une forme conique, et la résistance de charge, reliée en série avec l'éclateur, présente un axe de révolution, l'impédance de la ligne étant constante tout le long de ladite ligne.

2. Générateur d'impulsions selon la revendication 1, caractérisé en ce que l'extrémité (12a) de l'électrode interne (12), en regard de l'électrode, externe (14) présente une forme convexe.

3. Générateur d'impulsions selon la revendication 2, caractérisé en ce que la partie (16) de l'électrode externe (14) située en regard de l'extrémité (12a) de l'électrode interne (12) présente une forme plane.

4. Générateur d'impulsions selon l'une quelconque des revendications 1 à 3, caractérisé en ce que le condensateur (2) est disposé autour d'un support cylindrique isolant (36) dans lequel est logé le conducteur interne (5), l'ensemble constituant une ligne coaxiale.

5. Générateur d'impulsions selon l'une quelconque des revendications 1 à 4, caractérisé en ce que la résistance de charge (8) est constituée d'une nappe, d'un électrolyte aqueux (42) dont l'épaisseur varie de façon inversement proportionnelle au rayon de ladite nappe.

6. Générateur d'impulsions selon l'une quelconque des revendications 3 à 5, caractérisé en ce qu'il comprend une gâchette (20) placée dans un alésage (22) pratiqué dans la partie plane (16) de l'électrode externe (14).

7. Générateur d'impulsions selon la revendication 6, caractérisé en ce que les moyens de commande (10) de l'éclateur comprennent un autre condensateur (26) pouvant être chargé au moyen d'une autre source d'alimentation électrique continue, un autre éclateur (24) permettant de décharger de façon impulsionnelle ledit autre condensateur (26) et un transformateur d'isolement (28) dont le primaire (30) est connecté entre ledit autre condensateur et la masse de ladite autre source d'alimentation et dont le secondaire (32) est relié entre l'électrode externe (14) et la gâchette (20).

**Patentansprüche**

1. Generator elektromagnetischer Hochspannungsimpulse, enthaltend:
- einen Kondensator (12), der eine Drehachse (4) aufweist und der um einen Innenleiter (5) angeordnet ist, der eine Drehachse darstellt, die mit der des Kondensators zusammenfällt, wobei der Kondensator mittels einer elektrischen Hochspannungsstromquelle geladen werden kann,
- eine Entladefunkenstrecke (6), deren Drehachse mit der des Kondensators zusammenfallen kann und die wenigstens zwei Elektroden aufweist, eine äußere Elektrode (I4) und eine innere Elektrode (12), und die den Kondensator impulsweise entladen kann,
- einen Ladewiderstand (6), wobei die äußere Elektrode (14) der Entladefunkenstrecke (6) direkt mit dem Hochspannungsanschluß der elektrischen Stromquelle verbunden ist und die innere Elektrode (12) der Entladefunkenstrecke (6) mit dem Masseanschluß der genannten Stromversorgungsquelle über den Innenleiter (5) und den Ladewiderstand (8) verbunden ist, und
- Einrichtungen (10, 18) zur Steuerung der Entladefunkenstrecke, wobei der Kondensator, die Entladefunkenstrecke und der Ladewiderstand mit dem Innenleiter eine Koaxialleitung bilden, dadurch <u>gekennzeichnet</u>, daß die Entladefunkenstrecke (6) eine konische Form aufweist und daß der Ladewiderstand, der in Serie mit der Entladefunkenstrecke geschaltet ist, eine Drehachse aufweist, wobei die Impedanz der Leitung längs der genannten Leitung konstant ist.

2. Impulsgenerator nach Anspruch 1, dadurch <u>gekennzeichnet</u>, daß das Ende (12a) der Innenelektrode (12) gegenüber der Außenelektrode (I4) eine konvexe Form aufweist.

3. Impulsgenerator nach Anspruch 2, dadurch <u>gekennzeichnet</u>, daß der Abschnitt (16) der Außenelektrode (14), der dem Ende (12a) der Innenelektrode (12) gegenübersteht, eine ebene Gestalt aufweist.

4. Impulsgenerator nach einem der Ansprüche 1 bis 3, dadurch <u>gekennzeichnet</u>, daß der Kondensator (2) um einen isolierenden zylindrischen Halter (36) angeordnet ist, in welchem der Innenleiter (5) angeordnet ist, wobei die Anordnung eine Koaxialleitung bildet.

5. Impulsgenerator nach einem der Ansprüche 1 bis 4, dadurch <u>gekennzeichnet</u>, daß der Ladewiderstand (8) aus einem Mantel aus einem wässrigen Elektrolyt (42) gebildet ist, dessen Dicke umgekehrt proportional zum Radius des Mantels variiert.

6. Impulsgenerator nach einem der Ansprüche 3 bis 5, dadurch <u>gekennzeichnet</u>, daß er ein Verschlußelement (20) enthält, das in einer Bohrung (22) sitzt, die in dem ebenen Abschnitt (16) der Außenelektrode (14) ausgebildet ist.

7. Impulsgenerator nach Anspruch 6, dadurch <u>gekennzeichnet</u>, daß die Steuereinrichtungen (10) für die Entladefunkenstrecke weiterhin enthalten: einen weiteren Kondensator (26), der mittels einer anderen elektrischen Gleichstromquelle geladen werden kann, eine weitere Entladefunkenstrecke (24), die den genannten weiteren Kondensator impulsweise entladen kann, und einen Trenntransformator (28), dessen Primärseite (30) zwischen den weiteren Kondensator und den Masseanschluß der anderen Stromversorgungsquelle geschaltet ist und dessen Sekundärseite (32) zwischen die Außenelektrode (14) und das Verschlußelement (20) geschaltet ist.

**Claims**

1. High voltage electromagnetic pulse generator comprising:
- a capacitor (2) having an axis of revolution (4), placed around an internal conductor (5) having an axis of revolution merged with that of the capacitor, it being possible to charge this capacitor by means of a high voltage d.c. power supply,

- a spark gap (6), whose axis of revolution can be merged with that of the capacitor, including at least two electrodes, an external electrode (14) and an internal electrode (12), and enabling a pulsed discharge of the capacitor,
- a load resistor (8), the external electrode (14) of the spark gap (6) being directly connected to the high voltage terminal (HT) of the electrical power supply and the internal electrode (12) of the said spark gap (6) being connected to the ground of the said power supply, by means of an internal conductor (5) and the load resistor (8), and - means (10, 18) of controlling the spark gap, the capacitor, the spark gap and the load resistor forming with the internal conductor a coaxial line, characterized in that the spark gap (6) has a conical shape, and the load resistor, connected in series with the spark gap, has an axis of revolution, the impedance of the line being constant over the whole length of the said line.

2. Pulse generator according to Claim 1, characterized in that the end (12a) of the internal electrode (12), facing the external electrode (14) has a convex shape.

3. Pulse generator according to Claim 2, characterized in that the part (16) of the external electrode (14) facing the end (12a) of the internal electrode (12) has a plane shape.

4. Pulse generator according to any one of Claims 1 to 3, characterized in that the capacitor (2) is placed around an insulating cylindrical support (36) in which is housed the internal conductor (5), the assembly forming a coaxial line.

5. Pulse generator according to any one of Claims 1 to 4, characterized in that the load resistor (8) is formed from a sheet of aqueous electrolyte (42) whose thickness varies in a way that is inversely proportional to the radius of the said sheet.

6. Pulse generator according to any one of Claims 3 to 5, characterized in that it includes a trigger (20) placed in a bore (22) made in the plane part (16) of the external electrode (14).

7. Pulse generator according to Claim 6, characterized in that the means for controlling the spark gap include another capacitor (26) which can be charged by means of another d.c. electrical power supply, another spark gap (24) enabling the said other capacitor (26) to be discharged in a pulsed way and an isolating transformer (28) whose primary is connected betwéen the said other capacitor and the ground of the said other power supply and whose secondary (32) is connected between the external electrode (14) and the trigger (20).

FIG. 1

FIG. 2

FIG. 3